(19) Europäisches Patentamt
European Patent Office
Office européen des brevets

(11) Veröffentlichungsnummer: **0 057 738**
**B1**

(12) **EUROPÄISCHE PATENTSCHRIFT**

(45) Veröffentlichungstag der Patentschrift: **15.10.86**

(51) Int. Cl.⁴: **H 01 L 21/00**, H 01 L 21/60, H 01 L 21/90

(21) Anmeldenummer: **81100884.6**

(22) Anmeldetag: **07.02.81**

(54) **Verfahren zum Herstellen und Füllen von Löchern in einer auf einem Substrat aufliegenden Schicht.**

(43) Veröffentlichungstag der Anmeldung: **18.08.82 Patentblatt 82/33**

(45) Bekanntmachung des Hinweises auf die Patenterteilung: **15.10.86 Patentblatt 86/42**

(84) Benannte Vertragsstaaten: **DE FR GB IT**

(56) Entgegenhaltungen: **FR-A-2 356 739**

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB IT**

(72) Erfinder: **Moritz, Holger, Ulmenstrasse 118, D-7031 Holzgerlingen (DE)**

(74) Vertreter: **Oechssler, Dietrich, Dr.rer.nat. Dipl.-Chem., Schönaicher Strasse 220, D-7030 Böblingen (DE)**

**EP 0 057 738 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

**Beschreibung**

Die Erfindung betrifft ein Verfahren zum Herstellen und Füllen von Löchern in einer auf einem Substrat aufliegenden Schicht aus einem ersten Material, bei dem auf der Schicht eine Maske aufgebracht wird, welche durchgehende Öffnungen, die dem gewünschten Lochmuster entsprechen und überhängende Wände haben, aufweist, bei dem dann die Schicht aus dem ersten Material unter Verwendung der Maske als Ätzmaske mit einem Verfahren geätzt wird, bei dem ein Angriff im wesentlichen senkrecht zur Schichtoberfläche erfolgt, anschließend ein zweites Material zum Füllen der Löcher ganzflächig aufgebracht wird und schließlich die Maske mit dem auf ihr liegenden zweiten Material abgehoben wird.

Zur Herstellung von Halbleiterbauelemente untereinander verbindenden Leiterzugnetzen ist es bisher üblich, zunächst in eine auf dem Halbleitersubstrat aufgebrachte Isolierschicht Löcher an den Stellen zu ätzen, an welchen Kontakte zum Halbleitersubstrat erzeugt werden sollen. Anschließend werden die Kontakte und das Leiternetz erzeugt, indem entweder zunächst ganzflächig eine Schicht aus dem Leitermaterial, bevorzugt mittels Aufdampfens, aufgebracht wird und anschließend auf photolithographischem Weg das Leiternetz erzeugt wird, oder indem zunächst eine Photolackschicht aufgebracht wird, in welcher das Negativ des gewünschten Musters von Leiterzügen und Kontakten erzeugt wird, anschließend ganzflächig das Leiterzugmaterial aufgedampft und schließlich der Photolack mit dem auf ihm liegenden Leiterzugmaterial abgehoben wird. Sollen die Leiterzüge nicht nur in einer, sondern in zwei Ebenen verlaufen, so werden nach Aufbringen einer weiteren Isolierschicht zur Herstellung der zweiten Leiternetzebene die eben beschriebenen Verfahrensschritte zur Herstellung der ersten Ebene wiederholt. Sollen drei oder mehr Leiterzugebenen erzeugt werden, so werden die angegebenen Verfahrensschritte ab dem Aufbringen der Isolierschicht ein- oder mehrfach wiederholt. Dadurch, daß die Schichten aus dem Leitermaterial nicht eine durchgehende Schicht, sondern eine Schicht mit Löchern bedecken, sind sie nicht eben, sondern weisen Stufen auf. Je mehr Leiternetzebenen erzeugt werden, desto größer wird die Anzahl und/oder die Höhe dieser Stufen. Im Bereich der Stufen ist die Schichtdicke der Schicht aus Leitermaterial dünner als dort wo die Schicht parallel zur Substratoberfläche verläuft, und zwar ist die Schichtdicke umso dünner, je größer die Stufenhöhe und je steiler die Stufe ist. Bei Stufenhöhen von ungefähr 2 µm und einer Dicke der Schicht aus Leitermaterial im horizontalen Bereich von 1 bis 1,3 µm, wirken sich die genannten Schichtdickenunterschiede so aus, daß im Bereich der Stufen Unterbrechungen entweder bereits bei der Herstellung oder nach kurzem Gebrauch des Bauteils im Feld auftreten, wodurch das Bauteil mindestens teilweise unbrauchbar gemacht wird. Das genannte Problem kann bei der besprochenen Technik nur dadurch umgangen werden, daß die Dicke der Schicht aus dem Leitermaterial entsprechend erhöht wird, wobei, da die Unebenheit mit der Zahl der Leiternetzebenen zunimmt, mit jeder weiteren Leiternetzebene die Dicke der Leiternetzebene gegenüber der der vorangegangenen erhöht werden muß. Eine Erhöhung der Schichtdicke hat jedoch den großen Nachteil, daß auch die erreichbaren minimalen, lateralen Abmessungen der Leiterzüge größer werden, was dem Trend in der Halbleitertechnik zu immer kleineren Abmessungen der Halbleiterbauelemente und zu deren dichterer Packung entgegengerichtet ist.

In der DE-A- 27 29 030 wird ein Verfahren beschrieben, durch das das Auftreten von unebenen Schichten aus Leitermaterial wenigstens teilweise vermieden wird. Bei diesem Verfahren wird auf einer Isolierschicht eine Photolackmaske aufgebracht, welche dort Öffnungen aufweist, wo Löcher in die Isolierschicht geätzt werden sollen. Unter Verwendung der Photolackmaske als Ätzmaske werden dann durchgehende Löcher in die Isolierschicht geätzt und anschließend wird unter Verwendung der Photolackmaske als Aufdampfmaske Leitermaterial ganzflächig aufgedampft, und schließlich wird die Photolackmaske und das auf ihr liegende Leitermaterial durch Eintauchen in ein geeignetes Lösungsmittel abgehohen. Anschließend wird Leitermaterial, aus welchem anschließend das Leiternetz erzeugt wird, ganzflächig aufgedampft. Das Verfahren ist zwar dadurch vorteilhaft, daß das Aufdampfen "selbstjustiert" zum Ätzen der Löcher erfolgt. Weniger günstig ist jedoch, daß die Dicke der zuerst aufgedampften Schicht kleiner sein muß als die Dicke der Isolierschicht. Wären die Dicken gleich, so wäre eine Brückenbildung zwischen dem in den Löchern aufgedampften Material und dem auf die Photolackmaske aufgedampften Material und damit verbundene, nicht tolerierbare Schwierigkeiten beim Abhebeprozeß unvermeidlich. Da also bei dem in der DE-OS beschriebenen Verfahren die Dicke des in den Löchern aufgebrachten Materials geringer sein muß als die Dicke der Isolierschicht, ist notwendigerweise die Schicht aus Leitermaterial, welche zur Herstellung des Leiternetzes nach dem Abheben des Photolacks aufgebracht wird, uneben. Es kommt hinzu, daß bei dem in der DE-A beschriebenen Verfahren zwischen den in den Löchern aufgebrachtem Material und den Lochwänden ein Spalt vorhanden ist, welcher noch zusätzlich zu einer Unebenheit der danach aufgebrachten Schicht aus Leitermaterial beträgt, so daß in jedem Fall bei dem in der DE-OS beschriebenen Verfahren dieselben Schwierigkeiten wie bei dem älteren, oben angeführten Stand der Technik, wenn auch sicher in geringerem Maß auftreten. Als potentielles Problem kommt bei dem in der DE-OS beschriebenen Verfahren noch hinzu, daß die Gefahr besteht, daß die beim Abheben des photolacks benutzten Chemikalien auch bei sehr intensivem Spülen nicht vollständig aus dem erwähnten Spalt entfernt werden und dann später Ursache einer Korrosion sein können.

Ein ähnliches Verfahren wie in der DE-OS, bei dem es jedoch nicht notwendig ist, daß das in den Löchern aufgebrachte Material dünner ist als die Isolierschicht, ist in der EP-A-0 001 038 beschrieben. Bei diesem Verfahren wird als Maske beim Ätzen der Isolierschicht und beim Aufdampfen des Leitermatérials zum Füllen der Durchgangslöcher eine Maske aus Silicium verwendet, welche Maskenöffnungen aufweist, deren Wände überhängen, d. h., daß ihr Querschnitt mit zunehmendem Abstand von der Isolierschichtoberfläche kleiner

wird. Der Überhang verhindert eine Brückenbildung zwischen dem in den Durchgangslöchern und dem auf der Maske aufgebrachten Material, weshalb kein Problem auftritt, wenn die aufgedampfte Schicht genauso dick ist wie die Isolierschicht. Jedoch tritt auch bei dem in der europäischen Patentanmeldung beschriebenen Verfahren der Spalt zwischen dem in den Löchern aufgebrachten Material und den Lochwänden und die damit verbundene Unebenheit der nach dem Abheben der Maske aufgebrachten Schicht aus Leitermaterial auf. Der Spalt resultiert daraus, daß das Leitermaterial mit zunehmender Schichtdicke immer weiter in lateraler Richtung über den Rand der Maskenöffnungen hinauswächst, was praktisch auf eine Verkleinerung der Maskenöffnungen hinausläuft. Es kommt hinzu, daß die Siliciummaske sehr teuer ist und deshalb nur dann wirtschaftlich eingesetzt werden kann, wenn das mit ihr übertragbare Lochmuster sehr oft Anwendung findet.

Es ist die Aufgabe der Erfindung, ein relativ einfaches Verfahren anzugeben, um in einer Schicht durchgehende Löcher zu erzeugen und in diese dann Material in der Weise einzubringen, daß die Löcher vollständig gefüllt sind und daß die Oberfläche des Materials mit der Oberfläche der Schicht praktisch koplanar ist.

Diese Aufgabe wird mit einem Verfahren der eingangs genannten Art mit dem Merkmal des kennzeichnenden Teils des Anspruchs 1 gelöst.

Das erfindungsgemäße Verfahren benutzt das normalerweise als Nachteil angesehene Dünnen der Ätzmaske dazu, um das Problem des allmählichen Zuwachsens der Maskenöffnungen beim Einbringen des Materials in die Löcher unschädlich zu machen. Wird als erstes Material ein Isoliermaterial und als zweites Material ein Metall verwendet, so ist das erfindungsgemäße Verfahren in hervorragender Weise dazu geeignet, bei der Herstellung von ein- oder mehrlagigen Leiternetzen eingesetzt zu werden, da bei seiner Anwendung die beim Stand der Technik aufgetretenen Probleme bezüglich der durch die Durchgangslöcher verursachten Unebenheit der Leiternetze und der unvollständigen Füllung der Durchgangslöcher vermieden werden. Die erfindungsgemäß hergestellte Struktur ist dabei auch dann noch sehr vorteilhaft, wenn sie nicht unter optimalen Bedingungen hergestellt worden ist und deshalb das Material in den Löchern nicht vollständig planar ist, da sich nämlich herausgestellt hat, daß derartige Unebenheiten nach dem Aufbringen der nachfolgenden Schicht aus Leitermaterial stark vermindert werden.

Es ist vorteilhaft, wenn als Maskenmaterial ein positiver Photolack verwendet wird. Mit positiven Photolacken lassen sich auf einfache Weise und reproduzierbar Maskenmuster mit durchgehenden Löchern herstellend deren Wände überhängen. In allen Einzelheiten ist diese Herstellung von Masken in der DE-A- 28 55 723 beschrieben.

In vorteilhafter Weise wird das Ätzen des Isoliermaterials mittels reaktiven Ionenätzens in einer Glimmentladung durchgeführt. Bei diesem Ätzverfahren läßt sich das für die Durchführung des erfindungsgemäßen Verfahrens wichtige Verhältnis der Geschwindigkeiten mit denen einerseits das Maskenmaterial, andererseits die Schicht, in welche die Löcher eingebracht werden sollen, unter Berücksichtigung der Geometrie der Ätzvorrichtung reproduzierbar über die Natur des verwendeten Ätzgases, den Gasdruck, den Gasfluß und die Hochfrequenzenergie festlegen.

Weitere vorteilhafte Ausgestaltungen des erfindungsgemäßen Verfahrens sind in den Unteransprüchen angegeben.

Die Erfindung wird anhand von durch Zeichnungen erläuterten Ausführungsbeispielen beschrieben.

Es zeigen:

Fign. 1 bis 5

in schematischer Querschnittsdarstellung verschiedene Stadien der Herstellung einer Maske, welche vorteilhaft bei dem erfindungsgemäßen Verfahren eingesetzt werden kann, und

Fign. 6 bis 9

in schematischer Querschnittsdarstellung verschiedene Stadien der Herstellung von mit einem zweiten Material gefüllten Löchern in einer Schicht aus einem ersten Material gemäß dem erfindungsgemäßen Verfahren.

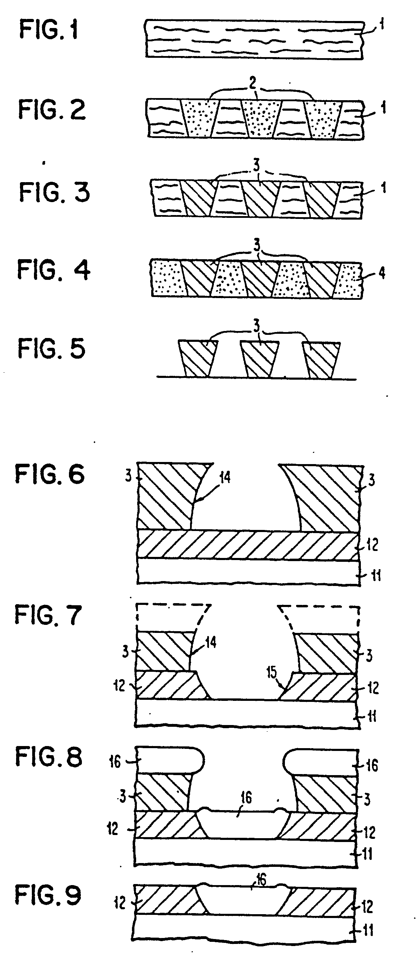

Im folgenden wird anhand eines Ausführungsbeispieles, bei welchem in einer Schicht Löcher erzeugt und diese dann mit einem eingebrachten Material vollständig gefüllt werden, das erfindungsgemäßen Verfahren beschrieben, wobei die Figuren 1 bis 9 zur Verdeutlichung herangezogen werden. Ausgegangen wird (siehe Fig. 6) von einer Schicht 12, welche auf einem Substrat 11 aufgebracht ist. Bei dem Ausführungsbeispiel besteht die Schicht 12 aus Siliciumdioxid, es sei aber klargestellt, daß die Schicht 12 auch aus anderen Materialien, insbesondere auch aus anderen Isoliermaterialien, wie z. B. Siliciumnitrid oder Polyimid; bestehen kann. Auf der Schicht 12 wird nun eine Maske 3 erzeugt, welche Öffnungen gemäß dem in der Schicht 12 gewünschten Lochmuster aufweist, wobei die Öffnungen überhängende Wände haben sollen. Als Maskenmaterial ist positiver Photolack günstig, weil sich einerseits aus ihm gemäß einem in der DE-A-28 55 723 beschriebenen Verfahren auf einfache Weise eine Maske mit einem Muster von Öffnungen, welche überhängende Wände aufweisen, reproduzierbar herstellen läßt, und er andererseits gemeinsam mit Siliciumdioxid in einem Ätzschritt geätzt werden kann. Zwar ist der positive Photolack ein besonders günstiges Maskenmaterial, jedoch ist die Anwendung des erfindungsgemäßen Verfahrens nicht auf die Anwendung von Masken aus diesem Material beschränkt.

Anhand der Fign. 1 bis 5 wird nun im folgenden die Herstellung einer Maske 3 beschrieben. Zunächst wird eine Mischung aus einem Positivlackmaterial und einem Vernetzungsmittel hergestellt. Geeignete Positivlackmaterialien sind beispielsweise phenol-Formaldehyd-Harze (Novolake) mit einem Diazonaphtochinon-Inhibitor. Solche Lacke sind in der US-A-3 201 239 beschrieben. Vorteilhafte Vertreter

dieser Positivlackmaterialien sind die von der Firma Shipley Company, Inc., Newton, Mass. V. St. A. unter dem Handelsnamen AZ-7350-H und J vertriebenen Materialien. Als Vernetzungsmittel wird eine Verbindung mit der allgemeinen Formel

$$R - \overset{\overset{O}{\|}}{C} - \overset{\overset{H}{|}}{N} - CH_2 - CH_2 - \overset{\overset{H}{|}}{N} - (CH)_2\,OH,$$

verwendet,

wobei R für einen Alkylrest steht, welcher bevorzugt zwischen 7 und 17 Kohlenstoffatome enthält. Diese Verbindung läßt sich günstig aus dem im Handel erhältlichen 1-Hydroxy-äthyl-2-alkylimidazolin, welches von der Firma Mona Ind., Inc., Paterson, New Jersey, V. St. A. unter dem Handelsnamen Monazoline C vertrieben wird, durch Hydrolyse erzeugen, indem ein Mol Monazoline C mit einem Mol Wasser umgesetzt wird. Eine festgelegte Menge des Reaktionsprodukts wird in einer kleinen Menge eines Lösungsmittels, wie z. B. Cellosolveazetat, gelöst und dann mit einer so großen Menge des positivlackmaterials vermischt, daß die Mischung zwischen etwa 1 und etwa 3 g Vernetzungsmittel pro 100 ml Mischung enthält.

Zur Erzeugung der Lackschicht wird eine kleine Menge der Mischung auf die Unterlage, auf welcher die Lackmaske erzeugt werden soll, bevorzugt durch Aufschleudern aufgebracht. Die Dicke der aufgebrachten Schicht 1 (siehe Fig. 1) liegt bevorzugt zwischen etwa 1,5 und 6 µm. Die Schichtdicke wird über die Umdrehungsgeschwindigkeit des Schleudertisches gesteuert.

Anschließend wird die Lackschicht 1 bei Temperaturen im Bereich zwischen etwa 85 und etwa 105°C zwischen etwa 10 und etwa 20 Minuten lang vorgehärtet und dann durch ein Maskenmuster hindurch bestrahlt. Zum Bestrahlen sind UV-Licht und Elektronenstrahlung geeignet. Beim Bestrahlen wird in den nicht von der Bestrahlungsmaske abgedeckten Bereichen die photoaktive Verbindung bzw. der Inhibitor abgebaut, und zwar beginnt die Zersetzung an der Oberfläche der Lackschicht 1. Die Fig. 2 gibt die tatsächliche, jedoch nicht sichtbare Veränderung der Schicht 1 nach dem Bestrahlen durch die Bestrahlungsmaske wieder.

Der durch das Maskenmuster hindurch bestrahlte Lackfilm wird bei Temperaturen im Bereich zwischen etwa 95 und etwa 110°C zwischen etwa 10 und etwa 60 Minuten lang erhitzt. Dabei findet in den zuvor bestrahlten Bereichen 2 der Lackschicht eine chemische Reaktion statt, bei der offenbar das Vernetzungsmittel dort, wo der Inhibitor abgebaut worden ist; mit den Polymermolekülen des Lacks in der Weise reagiert, daß eine Vernetzung stattfindet, wobei die zuvor löslich gemachten Bereiche der Lackschicht wieder unlöslich werden. Die bei diesem Verfahrensschritt aus den Bereichen 2 erzeugten, tatsächlich nicht sichtbaren, unlöslichen Bereiche 3 zeigt die Fig. 3. Für die Temperaturbehandlung wird ein relativ einfacher Ofen verwendet, welcher eine Einstellung der Temperatur auf ± 1° erlaubt. Üblicherweise wird die Temperaturbehandlung in einer Stickstoffatmosphäre durchgeführt.

Nach der Temperaturbehandlung wird die Lackschicht ganzflächig bestrahlt. Zum Bestrahlen kann dieselbe Vorrichtung wie zum bildmäßigen Bestrahlen verwendet werden. Es ist jedoch auch möglich, zum Bestrahlen einfach eine UV-Lampe hoher Intensität, wie z. B. eine 200 Watt-Quecksilber-Höchstdrucklampe, zu verwenden. Für eine ungefähr 2 µm dicke Lackschicht sind bei Verwendung der 200 Watt-Lampe ungefähr 50 Sekunden eine vernünftige Bestrahlungsdauer. Bei der ganzflächigen Bestrahlung wird in den in der Fig. 4 mit dem Bezugszeichen 4 bezeichneten Bereichen der Inhibitor abgebaut, d. h. die Bereiche 4 werden in dem für den eingesetzten Positivlack anzuwendenden Entwickler leicht löslich. Beim Entwickeln bleiben die beim Bestrahlen durch das Bestrahlungsmuster hindurch bestrahlten Bereiche stehen, und die beim ersten Bestrahlen abgedeckten Bereiche, d. h. die Bereiche 4 in der Fig. 4 werden weggelöst. Es entsteht also in der Lackschicht ein Negativ des Bestrahlungsmaskenmusters. Die nach dem Entwickeln vorliegende, aus den Bereichen 3 bestehende Maske zeigt die Fig. 5. um Entwickeln sind alle zum Entwickeln der Positivlacke auf Novolakbasis gebräuchlichen alkalische Entwickler geeignet. Zu diesen gehören u. a. wässriges, gepuffertes Alkali, wie z. B. eine wässrige Lösung von Natriumdihydrogenphosphat, Natriummetasilikat und Natrium hydroxid und eine wässrige Lösung von Natriummetaphosphat und Natriumdihydrogenphosphat. Die beiden zuletztgenannten Chemikalien bilden die wesentlichen Bestandteile des von der Firma Shipley Company, Inc. unter dem Handelsnamen AZ-Entwickler vertriebenen Produkts, welches im Verhältnis 1:1 mit destilliertem Wasser verdünnt, sich besonders zum Entwickeln der von dieser Firma vertriebenen Positivlacke eignet. Die erforderliche Zeit, um eine ungefähr 2 µm dicke Lackschicht zu entwickeln, liegt in der Größenordnung von 10 Minuten.

Günstig ist es, bei der Herstellung der Maske 3 gemäß der folgenden Ausführungsvorschrift vorzugehen:

5 g des Vernetzungsmittels werden in 25 ml Cellosolveazetat gelöst, und dann werden zu dieser Lösung 225 ml AZ-1350 J gegeben. Vor der weiteren Verwendung des Positivlacks läßt man die benötigte Menge durch ein Filter laufen.

Die Positivlackmischung wird bei 2500 Upm 30 Sekunden lang auf die Unterlage aufgeschleudert. Dabei entsteht eine 2,0 bis 2,1 µm dicke Schicht. Anschließend wird die Lackschicht 20 Minuten lang bei 85°C getrocknet.

Daraufhin wird die Lackschicht durch ein Bestrahlungsmaskenmuster hindurch belichtet. Als

Belichtungsgerät kann dabei beispielsweise das von der Firma Perkin-Elmer unter dem Handelsnamen "Micralign-PMA 100" vertriebene Gerät verwendet werden. Dieses Gerät arbeitet mit Projektionsbelichtung, wobei die Bestrahlungsmaske 1:1 übertragen wird. Die Belichtung der Lackmaske erfolgt streifenweise. Versuche haben ergeben, daß bei der Rastergeschwindigkeitseinstellung 025 eine Lackmaske erhalten wird, die sehr gut mit dem Bestrahlungsmaskenmuster, durch das bestrahlt wird, übereinstimmt. Die Festlegung der Bestrahlungszeit erfolgt in der Weise, daß mehrere Proben verschiedenen lang belichtet werden, dann die beim Enwickeln erhaltenen Maskendimensionen gemessen und mit den Dimensionen des Bestrahlungsmaskenmusters vergliechen werden. Je nach der gewünschten sytematischen Abweichungen der Lackmaskendimensionewn von den Dimensionen der Bestrahlungsmaske (0 oder ± x) wird dann die Bestrahlungszeit festgelegt. Nach dem bildmäßigen Belichten wird die Lackschicht einer Temperaturbehandlung bei 100°C, welche etwa 50 Minuten dauert und in einer Stickstoffatmosphere stattfindet, unterworfen. Dann wird die Lackschicht durch eine Glasschicht hindurch mittels des Micralign-Geräts bestrahlt, wobei die Rastergeschwindigkeitseinstellung wiederum 025 sein kann.

Zum Entwickeln der Lackschicht wird AZ-Entwickler, welcher im Verhältnis 1:1 mit Wasser verdünnt worden ist, und einen $p_H$-Wert von ungefähr 12,8 hat, verwendet. Die Entwicklungszeit beträgt ungefähr 10 Minuten.

Nach dem Erzeugen der Maske 3 liegt eine Struktur vor, von der die Fig. 6 im Querschnitt einen Ausschnitt schematisch wiedergibt. Der gezeigte Ausschnitt aus der Maske 3 weist eine Öffnung 14 mit überhängenden Wänden auf. Die Schichtdicken der $SiO_2$-Schicht und der Maske 3 liegen zwischen ungefähr 0,5 und 4 bzw. zwischen 1,5 und 6 μm.

Im nächsten Verfahrensschritt folgt das Ätzen von Löchern 15 in die Siliciumdioxidschicht 12 unter Verwendung der Maske 3 als Ätzmaske. Das Ätzen wird bevorzugt mittels reaktiven Ionenätzens in einer Glimmentladung durchgeführt, jedoch sei klargestellt, daß auch andere Ätzverfahren, bei welchen der Ätzangriff im wesentlichen senkrecht zur Oberfläche der Schicht 12 erfolgt und welche gleichzeitig Siliciumdioxid und positiven Photolack (bzw. eine andere Materialkombination) ätzen, verwendet werden können. Beim reaktiven Ionenätzen wird bevorzugt $CF_4$ als Ätzgas eingesetzt. Günstige Ergebnisse werden erzielt, wenn bei einem Gasdruck zwischen etwa 13,3 und 66,6 μbar einem Gasfluß zwischen etwa 10 und etwa 100 $cm^3$/Min. und einer Hochfrequenzenergie im Bereich zwischen etwa 0,1 und 0,3 Watt/$cm^2$ gearbeitet wird. Unter diesen Bedingungen werden Siliciumdioxid mit einer Geschwindigkeit von etwa 20 bis etwa 25 nm/Min. und positiver Photolack mit einer Geschwindigkeit von etwa 15 bis etwa 20 nm/Min. abgetragen, wobei anzumerken ist, daß auch die Geometrie der Ätzvorrichtung auf die Ätzgeschwindigkeiten einen gewissen Einfluß hat. Besonders günstig ist es, wenn beim Ätzen mit einer Fließgeschwindigkeit von 20 $cm^3$/Min., einem Gasdruck von ungefähr 40 μbar und einer Hochfrequenzenergie von ungefähr 0,2 Watt/$cm^2$ gearbeitet wird. Da die Maske 3 nach dem Ätzen der Löcher 5 noch eine Mindestdicke aufweisen muß, muß die Maskendicke vor dem Ätzen in Abhängigkeit von dem Ätzgeschwindigkeitenverhältnis und der gewünschten Maskenmindestdicke nach dem Ätzen festgelegt werden. Bei den angegebenen Ätzbedingungen hat sich für das Verhältnis der Dicken der Maske 3 (vor dem Ätzen) und der Schicht 2 ein Richtwert von ungefähr 1,5 als günstig erwiesen. Einen Ausschnitt aus der Struktur nach dem Ätzen zeigt in schematischer Querschnittsdarstellung die Fig. 7. Der in der Fig. 7 gestrichelt eingerahmte weiße Bereich über der Maske 3 soll den beim Ätzen abgetragenen Teil der Maske veranschaulichen. Durch das Dünnen der Maske während des Ätzens vergrößert sich der den Ätzangriff bestimmende Querschnitt der Maskenöffnungen 14 kontinuierlich, was auf den Überhang der öffnungswände zurückzuführen ist. In den Bereichen der Schicht 12, welche dem Ätzangriff von Anfang an ausgesetzt sind, wird das Schichtmaterial vollständig weggeätzt; in den Bereichen, welche infolge der allmählichen Vergrößerung der Maskenöffnungen erst im Lauf des Ätzens dem Ätzangriff ausgesetzt werden, erfolgt nur eine teilweise Abtragung, wobei die abgefragene Schichtdicke proportional der Zeit ist, während der die einzelnen Bereiche der Schicht dem Ätzangriff ausgesetzt waren. Daraus resultiert das in der Fig. 7 schematisch wiedergegebene Profil des Lochs 15.

Im nächsten Schritt wird auf die in der Fig. 7 im Ausschnitt gezeigte Struktur ganzflächig ein Material aufgebracht, um die Löcher 15 zu füllen. Im vorliegenden Fall besteht das Material aus einem Metall, welches durch Aufdampfen aufgebracht wird. Die Löcher 15 können jedoch auch mit anderen Materialien und mittels anderer Methoden gefüllt werden, sofern dabei das Material gerichtet, und zwar senkrecht zur Oberfläche der Schicht 12, aufgebracht wird. beim Aufdampfen darf sich der Photolack nicht so stark erhitzen, daß er-anfängt zu fließen. Die Substrattemperatur sollte deshalb beim Aufdampfen etwa $<100°C$ sein. Es wird solange aufgedampft, bis das aufgedampfte Metall 16, beispielsweise eine Legierung aus Aluminium und Kupfer, etwa dieselbe Dicke wie die Schicht 12 hat. Das aufdampfende Material wächst auf der Maske 3 nicht nur vertikal auf, sondern auch in horizontaler Richtung über den Rand der Maskenöffnungen 14 hinaus und verkleinert dadurch zunehmend den Querschnitt der maskierten Bereiche. Diese allmähliche uerschnittverkleinerung bewirkt beim Stand der Technik (s. die EP-A-0 001 038) daß die Löcher in der Isolierschicht nicht vollständig gefüllt werden können. Bei dem erfindungsgemäßen Verfahren hingegen wirken das beim Ätzen erzeugte Lochprofil und die Querschnittsverkleinerung der maskierten Bereiche beim Aufdampfen in der Weise zusammen, daß dann, wenn das aufgedampfte Metall 16 dieselbe Dicke wie die Schicht 12 hat, die Löcher 15 gerade vollständig gefüllt sind, d.h., daß die Füllung mit dem Metall eine im wesentlichen ebene Oberfläche hat, welche koplanar mit der Schicht 12 ist, und kein Spalt zwischen der Füllung und den Lochwänden vorhanden nach dem Aufdampfen vorliegende Struktur zeigt ausschnittsweise in einer schematischen Querschnittsdarstellung die Fig. 8. Ist, wie es in den Fign. 8 und 9 angedeutet ist, die Metallfüllung 16 in den Löchern 15 nicht vollständig eben, beispielsweise weil die Bedingungen beim Ätzen und Aufdampfen nicht

optimal eingestellt waren, so ist das nicht kritisch. Bevorzugt wird nämlich, worauf weiter unten noch eingegangen wird, das erfindungsgemäße Verfahren beim Aufbau einer Leiternetzstruktur eingesetzt, wobei nach Fertigstellung der erfindungsgemäß hergestellten Struktur ganzflächig eine weitere Metallschicht aufgebracht wird, an deren Oberfläche geringen Unebenheiten, welche in der Oberfläche der Metallfüllungen 16 in den Löchern 15 vorhanden sind, praktisch ausgeglichen sind.

Im letzten Verfahrensschritt wird die Maske 3 und das auf ihr liegende Metall 16 abgehoben. Dazu wird die Struktur in heißes (100°C) N-Methylpyrrolidon getaucht, anschließend in Azeton und deionisiertem.Wasser gewaschen und schließlich getrocknet. Die dann vorliegende Struktur zeigt ausschnittsweise die Fig. 9 in einer schematischen Querschnittsdarstellung.

Bei Versuchen wurden mit dem erfindungsgemäßen Verfahren in eine Siliciumdioxidschicht Löcher geätzt und anschließend gefüllt, wobei der Durchmesser der Maskenöffnungen zwischen 3,5 und 5,5 µm lag. Bei allen Versuchen war der Durchmesser der fertigen Löcher jeweils 0,3 µm größer als der Durchmesser der Maskenöffnungen. Man kann also mit dem erfindungsgemäßen Verfahren gefüllte Löcher, deren Durchmesser nicht größer als einige µm ist, reproduzierbar unter Einhaltung sehr kleiner Toleranzen erzeugen. Damit ist das Verfahren zum Einsatz bei der Herstellung dichtgepäckter, hochintegrierter Schaltungen geeignet.

Sehr vorteilhaft läßt sich das erfindungsgemäße Verfahren bei der Herstellung ein- und mehrlagiger Leiternetze, welche die notwendigen leitenden Verbindungen in einem System integrierter Schaltungen herstellen, einsetzen.

Bei der Herstellung eines einlagigen Leiternetzes wird das erfindungsgemäße Verfahren angewandt, nachdem in einem Halbleitersubstrat die Halbleiterbauelemente erzeugt und dabei das Halbleitersubstrat vollständig mit Isoliermaterial abgedeckt worden ist. Das Halbleitersubstrat entspricht in diesem Fall dem Substrat 11 in der Fig. 6 und die Abdeckung aus isoliertem Material der Schicht 12. Mittels des erfindungsgemäßen Verfahrens wird die Abdeckung mit durchgehenden Kontaktlöchern versehen und eine Metallfüllung in die Löcher eingebracht. Anschließend wird zur Erzeugung des Leiternetzes auf der dann vorliegenden Struktur in bekannter Weise aus Photolack, beispielsweise mittels des in der DE-A- 28 55 723 beschriebenen Verfahren das Negativ des gewünschten Leiternetzes erzeugt, dann wird ganzflächig mit Metall bedampft und schließlich wird der Photolack und das auf ihm liegende Metall abgehoben. Das Leiternetz kann auch erzeugt werden, indem auf die isolierende Abdeckung ganzflächig Metall aufgedampft wird, dieses dann mit einer Photolackmaske, die dem Positiv des gewünschten Leiternetzmusters entspricht, versehen wird und schließlich die freiliegenden Metallbereiche weggeätzt werden. Bei einlagigen Leiternetzen sind Unebenheiten noch nicht so kritisch, so daß statt des erfindungsgemäßen Verfahrens alternativ auch bekannte Verfahren eingesetzt werden können, die mit einer Metallbedampfung, bei welcher sowohl die Löcher gefüllt als auch das Material für das Leiternetz aufgebracht wird, auskommen.

Eindeutige Vorteile gegenüber bekannten Verfahren hat jedoch das erfindungsgemäße Verfahren beim Herstellen zwei- und mehrlagiger Leiternetze, weil sich bei seiner Anwendung die Unebenheiten, welche bei den bekannten Verfahren im Bereich der Durchgangslöcher in den Isolierschichten zwischen zwei Leiterebenen auftreten und durch diese Löcher verursacht werden, weitgehend vermeiden lassen.

Beim Einsatz des erfindungsgemäßen Verfahrens beim Herstellen mehrlagiger Leiternetze geht man entweder - wie bei der Herstellung einlagiger Leiternetze von einem mit einer isolierenden Abdeckung versehenen, Halbleiterbauelemente enthaltenden Halbleitersubstrat oder von einer Struktur aus, bei der auf dem Halbleitersubstrat bereits eine mittels bekannter Verfahren hergestellte und mit einer Isolierschicht abgedeckte erste Leiterebene vorhanden ist (die isolierende Abdeckung bzw. die Isolierschicht entsprechen der Schicht 11 in der Fig. 6 und das, was mit der Abdeckung bzw. Isolierschicht abgedeckt ist, dem Suhstrat 12). Nachdem mittels des erfindungsgemäßen Verfahrens eine der in der Fig. 9 gezeigten Struktur entsprechende Struktur erzeugt worden ist, wird mittels einer der oben angegebenen Verfahren die erste bzw. die nächste Leiterebene erzeugt. Sollen eine weitere oder mehrere weitere Leiterebenen erzeugt werden, so werden - jeweils nach Aufbringen einer Isolierschichtdas erfindungsgemäße Verfahren und das Erzeugen der Leiterebene ein- oder mehrfach wiederholt.

Bei Anwendung des erfindungsgemäßen Verfahrens müssen - anders als beim Stand der Technik, wo dies infolge der vorhandenen großen Stufen nötig ist, - auch in den höheren Lagen der Leiternetze die Metallschichten nicht deshalb dicker als erwünscht gemacht werden, damit eine gute Stufenbedeckung gewährleistet ist. Bei Anwendung des erfindungsgemäßen Verfahrens können also auch in den höheren Lagen des Leiternetzes sehr schmale und dicht gepackte Leiterzüge gebildet werden.

**Patentansprüche**

1. Verfahren zum Herstellen und Füllen von Löchern (15) in einer auf einem Substrat aufliegenden Schicht (12) aus einem ersten Material, bei dem auf der Schicht (12) eine Maske (3) aufgebracht wird, welche durchgehende Öffnungen (14), die dem gewünschten Lochmuster entsprechen und überhängende Wände haben, aufweist, bei dem dann die Schicht (12) unter Verwendung der Maske (3) als Ätzmaske mit einem Verfahren geätzt wird, bei dem der Angriff im wesentlichen nur senkrecht zur Schichtoberfläche erfolgt, bei dem anschließend ein zweites Material (16), mit dem die Löcher (15) gefüllt werden sollen, ganzflächig aufgebracht und bei dem schließlich die Maske (3) mit dem auf ihr liegenden Material (16) abgehoben wird,

dadurch gekennzeichnet,
daß beim Ätzen der Schicht (12) aus dem ersten Material gleichzeitig die Maske (3) gedünnt wird.

2. Verfahren nach Anspruch 1,
dadurch gekennzeichnet,
daß als erstes Material ein Isoliermaterial, als zweites Material (16) ein Metall und als Maskenmaterial ein positiver Photolack verwendet wird.

3. Verfahren nach Anspruch 1 oder 2,
dadurch gekennzeichnet,
daß das Isoliermaterial aus der Gruppe $SiO_2$, $Si_3N_4$ und Polyimid ausgewählt wird.

4. Verfahren nach einem oder mehreren der Ansprüche 1 bis 3,
dadurch gekennzeichnet,
daß das Ätzen des ersten Materials mittels reaktiven Ionenätzens in einer Glimmentladung durchgeführt wird.

5. Verfahren nach Anspruch 4,
dadurch gekennzeichnet,
daß das Verhältnis der Ätzgeschwindigkeiten von Maskepmaterial zu Schicht (12) unter Berücksichtigung der Geometrie der Ätzvorrichtung festgelegt wird durch die Natur des Ätzgases, den Gasdruck, den Gasfluß und die Hochfrequenzenergie.

6. Verfahren nach einem oder mehreren der Ansprüche 1 bis 5,
dadurch gekennzeichnet,
daß das Verhältnis der Geschwindigkeiten, mit welchen die Schicht (12) und die Maske (3) abgetragen werden, und daß Verhältnis der Dicken dieser beiden Schichten so aufeinander abgestimmt werden, daß die Maske (3) nach dem Ätzen noch mindestens so dick wie die Schicht (12) ist.

7. Verfahren nach einem oder mehreren der Ansprüche 1 bis 6,
dadurch gekennzeichnet,
daß das Metall aufgedampft wird, wobei das Substrat nur auf eine Temperatur erhitzt wird, bei welcher der Photolack noch nicht zu fließen beginnt.

8. Verfahren nach einem oder mehreren der Ansprüche 2 bis 7,
dadurch gekennzeichnet,
daß zur Herstellung der Maske (3) eine Schicht (7) aus einem Positiven Photolack, welcher als Vernetzungsmittel eine Verbindung mit der allgemeinen Formel

$$R - \overset{\overset{\displaystyle O}{\|}}{C} - \overset{\overset{\displaystyle H}{|}}{N} - CH_2 - CH_2 - \overset{\overset{\displaystyle H}{|}}{N} - (CH)_2OH \quad \text{verwendet,}$$

in der R für eine Alkylgruppe steht, enthält, auf der Isolierschicht (12) aufgebracht, anschließend durch eine Bestrahlungsmaske, welche transparente Bereiche aufweist, welche dem Negativ des gewünschten Öffnungsmusters in der Maske (3) entspricht, bestrahlt, dann eine festgelegte Zeit auf eine festgelegte Temperatur erhitzt, daraufhin ganzflächig bestrahlt und schließlich entwickelt wird,
daß mittels reaktiven Ionenätzens in einer Glimmentladung unter Verwendung der Maske (3) als Ätzmaske durchgehende Löcher (15) in der Isolierschicht (12) unter gleichzeitigem Dünnen der Maske (3) erzeugt werden,
daß ganzflächig Metall (16) in einer Dicke aufgedampft wird, welche ungefähr gleich der der Isolierschicht (12) ist und
daß schließlich die Maske (3) und das auf ihr liegende Metall (16), beispielsweise durch Eintauchen in N-Methylpyrrolidon, abgehoben wird.

9. Verfahren nach Anspruch 8,
dadurch gekennzeichnet,
daß die aus $SiO_2$ bestehende Isolierschicht (12) zwischen etwa 0,5 und etwa 4 µm und die Maske (3) zwischen etwa 1,5 und etwa 6 µm dick gemacht werden, daß das reaktive Ionenätzen in einer $CF_4$-Atmosphäre bei einem Druck zwischen etwa 1,33 und etwa 6,66 µbar, einem Gasfluß zwischen etwa 10 und etwa 100 $cm^3$/Min. und einer Hochfrequenzenergie zwischen etwa 0,1 und etwa 0,3 Watt/$cm^2$ durchgeführt wird, daß als Metall (16) eine Aluminium-Kupferlegierung verwendet und die Substrattemperatur während des Aufdampfens unterhalb 100° C gehalten wird.

10. Verfahren nach einem oder mehreren der Ansprüche 1 bis 9,
gekennzeichnet durch seine Anwendung bei der Herstellung ein oder mehrlagiger Leiternetze auf Halbleiterbauelemente enthaltenden Halbleitersubstraten, wobei entweder von einem mit einer isolierenden Abdeckung versehenen Halbleitersubstrat oder einem Halbleitersubstrat, auf welchem sich ein das Halbleitersubstrat an festgelegten Stellen kontaktierendes und im übrigen von ihm isoliertes Leiternetz befindet, welches mit einer Isolierschicht bedeckt ist, ausgegangen wird, wobei nach Erzeugung der Maske in der isolierenden Abdeckung bzw. in der Isolierschicht Löcher erzeugt, diese mit Metall gefüllt, daraufhin auf der mit Metall gefüllten Löchern versehenen, isolierenden Abdeckung bzw. Isolierschicht eine Leiternetzebene gebildet wird und wobei, wenn mehr als eine Leiternetzebene benötigt wird, jeweils nach dem Aufbringen einer weiteren Isolierschicht die Verfahrensschritte ab der Erzeugung der Maske bis zur Bildung der

Leiternetzebene einoder mehrfach wiederholt werden.

## Claims

1. Method of making and filling holes (15) in a layer (12) of a first material on a substrate, wherein on the layer (12) a mask (3) is provided which has via openings (14) corresponding to the respective hole pattern and having overhanging walls, wherein subsequently the layer (12) is etched using the mask (3) as an etching mask in accordance with a method where the attack is effected substantially vertically to the layer surface, wherein subsequently a second material (16) with which the holes (15) are to be filled is applied in a blanket deposition, and wherein finally the mask (3) with the material (16) deposited thereon is lifted off, characterized in that while the layer (12) of the first material is etched the mask (3) is thinned simultaneously.

2. Method as claimed in claim 1,
characterized in that as a first material an insulation material, as second material (16) a metal, and as mask material a positive photoresist are used.

3. Method as claimed in claim 1 or 2,
characterized in that the insulation material is selected from the group containing $SiO_2$, $Si_3N_4$, and polyimide.

4. Method as claimed in one or several of claims 1 to 3,
characterized in that the first material is etched by means of reactive ion etching in a glow discharge.

5. Method as claimed in claim 4,
characterized in that the ratio of the etching speeds of mask material and the layer (12) is determined in consideration of the geometry of the etching device, and of the nature of the etching gas, the gas pressure, the gas flow, and the high frequency energy.

6. Method as claimed in one or several of claims 1 to 5, characterized in that the ratio of the speeds with which the layer (12) and the mask (3) are lifted off, and the ratio of the thicknesses of these two layers are adapted to each other in such a manner that after etching the mask (3) is still at least as thick as the layer (12).

7. Method as claimed in one or several of claims 1 to 6, characterized in that the metal is evaporated, with the substrate being heated only to a temperature at which the photoresist does not yet start flowing.

8. Method as claimed in one or several of claims 2 to 7, characterized in that for making the mask (3) a layer (7) of a positive photoresist containing as a cross-linking agent a compound of the general formula

$$R - \overset{\overset{O}{\|}}{C} - \overset{\overset{H}{|}}{N} - CH_2 - CH_2 - \overset{\overset{H}{|}}{N} - (CH)_2\ OH$$

with R representing an alkyl group, is applied on the insulation layer (12), that it is subsequently irradiated through an irradiation mask having transparent zones which correspond to the negative of the respective opening pattern in the mask (3), that it is subsequently heated to a predetermined temperature for a fixed period, and then exposed to a blanket irradiation and finally developed, that by means of reactive ion etching in a glow discharge, using the mask (3) as an etching mask, via holes (15) are made in the insulation layer (12) with the mask (3) being thinned simultaneously, that the metal (16) is evaporated in a blanket deposition with a thickness approximately equalling that of the insulation layer (12), and that finally the mask (3) and the metal (16) deposited thereon are lifted off, e. g. by immersion in N-methyl pyrrolidone.

9. Method as claimed in claim 8,
characterized in that the inuslation layer (12) consisting of $SiO_2$ has a thickness between approximately 0.5 and approximately 4 µm, and the mask (3) between approximately 1.5 and approximately 6 µm, that the reactive ion etching is effected in a $CF_4$ atmosphere at a pressure between approximately 1.33 and approximately 6.66 µbar, a gas flow between approximately 10 and approximately 100 $cm^3$/min., and a high frequency energy between approximately 0.1 and approximately 0.3-Watt/$cm^2$, that as a metal (16) an aluminum-copper alloy is used, and that during évaporation the substrate temperature is kept at below 100° C.

10. Method as claimed in any one of claims 1 to 9,
characterized by its use in the production of oneor multi-layer conductive networks on semiconductor substrates comprising semiconductor elements, the initial element being either a semiconductor substrate with an insulating cover, or a semiconductor substrate having a conductive network which contacts the semiconductor substrate in predetermined points and is insulated therefrom in its other parts, and which is covered with an insulation layer, holes being made in the insulating cover or in the insulation layer after the production of the mask, these holes being filled with metal, and subsequently a conductive network plane being made on the insulating cover or insulation layer with metal-filled holes, and with more than one conductive network plane being needed, the process steps being repeated after each application of an insulation layer from the production of the mask to the forming of the conductive network plane.

**Revendications**

1. Procédé pour fabriquer et remplir des trous (15) dans une couche (12) reposant sur un substrat et constituée d'un premier matériau, procédé dans lequel sur la couche (12) on dépose un masque (3) qui présente des ouvertures traversantes (14) qui correspondent au dessin désiré des trous et présentent des parois en surplomb, procédé dans lequel on attaque ensuite la couche (12), en utilisant le masque (3) comme masque d'attaque, avec un procédé dans lequel l'attaque ne fait sensiblement que perpendiculairement à la surface de la couche, dans lequel on dépose ensuite sur toute la surface un second matériau (16) avec lequel les trous (15) doivent être rempli et dans lequel enfin on emlève le masque (3) ainsi que le matériau (16) reposant sur lui,
caractérisé
en ce que lors de l'attaque de la couche (12) constitué du premier matériau, on amincit en même temps le masque (3).

2. Procédé selon la revendication 1,
caractérisé
en ce que comme premier matériau on emploi un matériau isolant, comme second matériau (16) un métal et comme matériau pour le masque, une laque photo-sensible de type positif.

3. Procédé selon l'une des revendications 1 ou 2,
caractérisé
en ce que l'on choisit le matériau isolant dans le groupe $SiO_2$, $Si_3N_4$ polymide.

4. Procédé selon une ou plusieurs revendications 1 à 3,
caractérisé
en ce que l'attaque du premier matériau s'exécute par une attaque ionique réactive par décharge dans un gaz.

5. Procédé selon la revendication 4
caractérisé
en ce que le rapport de la vitesse d'attaque du matériau du masque à celle de la couche (12) est déterminé, en tenant compte de la géométrie du dispositif d'attaque, par la nature du gaz d'attaque, de la pression de gaz, du débit du gaz et de l'énergie haute fréquence.

6. Procédé selon une ou plusieurs des revendications 1 à 5,
caractérisé
en ce que le rapport des vitesses, avec lesquelles la couche (12) et le masque (3) sont enlevés, et le rapport des épaisseurs de ces deux couches sont accordés l'un sur l'autre de façon qu'après l'attaque le masque (3) soit encore au moins aussi épais que la couche (12).

7. Procédé selon une ou plusieurs des revendications 1 à 6,
caractérisé
en ce que l'on dépose le métal par vaporisation sous vide, le substrat n'étant échauffé qu'à une température pour laquelle la laque photo sensible ne commence pas encore à fluer.

6. Procédé selon une ou plusieurs des revendications 2 à 7
caractérisé
en ce que pour fabriquer le masque (3) on dépose sur la couche isolante (12) une couche (1) d'une laque photo-sensible de type positif qui contient comme agent de réticulation une liaison de formule générale

$$R - \overset{O}{\overset{\|}{C}} - \overset{H}{\overset{|}{N}} - CH_2 - CH_2 - \overset{H}{\overset{|}{N}} - (CH)_2\ OH,$$

dans laquelle R représente un groupe alkyle; puis l'insole à travers un masque d'insolation qui présente des zones transparentes et qui correspond au négatif du dessin désiré d'ouverture dans le masque (3); puis on la chauffe pendant un temps prédéterminé à une température prédéterminée; puis on l'insole sur toute la surface; et enfin on la développe;
en ce qu'au moyen de l'attaque ionique réactive dans une décharge lumineuse, en utilisant le masque (3) comme masque d'attaque, on obtient des trous traversant (15) dans la couche isolante (12) tout en amincissant simultanément le masque (3);
En ce que sur toute la surface on dépose par vaporisation sous vide du métal (16) sous une épaisseur approximativement égale à celle de la couche isolante (12); et
en ce qu'enfin on enlève le masque (3) et le métal (16) placé sur lui, par exemple par immersion dans de la N-méthylpyrrolidone.

9. Procédé selon la revendication 6,
caractérisé
en ce que l'on donne à la couche isolante (12) constituée de $SiO_2$ une épaisseur entre environ 0,5 et environ 4 µm et au masque (3) une épaisseur entre environ 1,5 et environ 6 µm; en ce que l'attaque ionique réactive

s'exécute dans une atmosphère de $CF_4$ sous une pression entre environ 1,33 et 6,66 µbar, avec un débit de gaz entre environ 10 et environ 100 $cm^3$/min et avec une énergie haute fréquence entre environ 0,1 et environ 0,3 watt/$cm^2$; en ce que comme métal (16) on utilise un alliage aluminium/cuivre; et en ce que pendant la vaporisation sous vide la température du substrat est maintenue en-dessous de 100° C.

10. Procédé selon une ou plusieurs des revendications 1 à 9, caractérisé par son utilisation lors de la fabrication de réseaux conducteurs monocouche ou multicouche sur des substrats contenant des composants semi-conducteurs, étant précisé que l'on part soit d'un substrat pour semi-conducteurs présentant un revêtement isolant soit d'un substrat pour semi-conducteurs sur lequel se trouve un réseau conducteur qui est en contact avec le substrat pour semi-conducteurs a des emplacements déterminés, qui, par ailleurs en est isolé et qui est revêtu d'une couche isolante; étant précisé qu'après la production du masque, on produit dans le revêtement isolant ou dans la couche isolante des trous que l'on remplit de metal, puis que l'on forme, sur le revêtement isolant, ou sur la couche isolante, présentant des trous remplis de métal, un plan de réseaux conducteurs, et étant précisé que, si l'on a besoin de plus d'un plan de réseaux conducteurs, on répète une ou plusieurs fois, respectivement, après le dépôt d'une autre couche isolante, les étapes du procédé depuis la production du masque jusqu'a la formation du plan de réseaux conducteurs.

FIG. 1

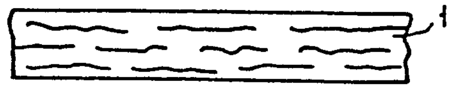


FIG. 2

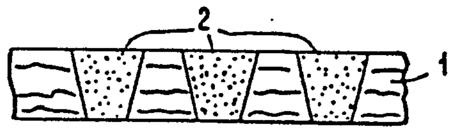


FIG. 3

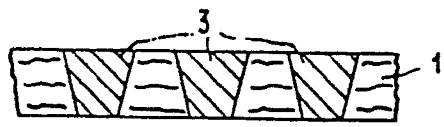


FIG. 4

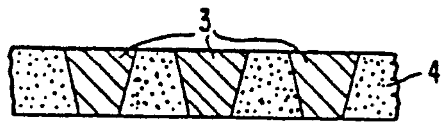


FIG. 5

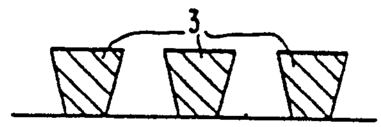


FIG. 6

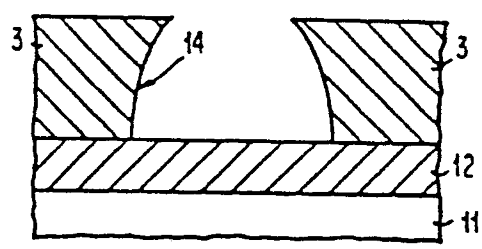


FIG. 7

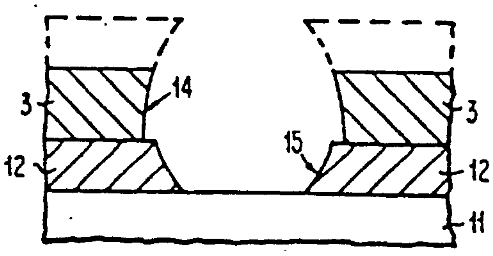


FIG. 8

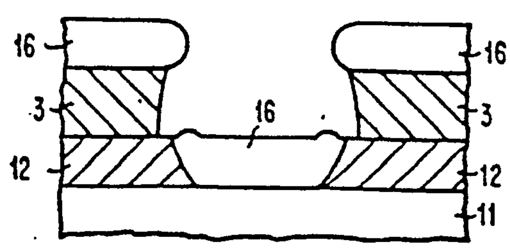


FIG. 9